# EUROPÄISCHE PATENTSCHRIFT

(11) **EP 4 244 083 B1**
(45) Veröffentlichungstag und Bekanntmachung des Hinweises auf die Patenterteilung: **11.12.2024**
(21) Anmeldenummer: 21809924.0
(22) Anmeldetag: 21.10.2021
(51) Int. Cl.: B60C 11/24, B60C 23/00

(54) **VERFAHREN UND VORRICHTUNG ZUM FESTSTELLEN EINER VALIDITÄT EINES REIFENPARAMETERS**
METHOD AND DEVICE FOR DETERMINING A VALIDITY OF A TIRE PARAMETER
PROCÉDÉ ET DISPOSITIF DE DÉTERMINATION DE VALIDITÉ DE PARAMÈTRE DE PNEUMATIQUE

(30) Priorität: 13.11.2020 DE 102020214321
(43) Veröffentlichungstag der Anmeldung: 20.09.2023
(73) Patentinhaber: Continental Automotive Technologies GmbH, 30175 Hannover (DE)
(72) Erfinder: KRETSCHMANN, Matthias, 90411 Nürnberg (DE)
(74) Vertreter: Continental Corporation
(86) Internationale Anmeldenummer: PCT/DE2021/200160
(87) Internationale Veröffentlichungsnummer: WO 2022/100796

(56) Entgegenhaltungen:
- EP-A2- 0 972 658
- WO-A2-2019/224641
- DE-A1- 102015 223 968
- US-A1- 2019 009 618

## Beschreibung

Moderne Fahrzeuge verfügen üblicherweise über Vorrichtungen zum Überwachen von diversen Reifenparametern eines Fahrzeugreifens, wie beispielsweise eines Reifendrucks, einer Reifenprofiltiefe oder anderen Reifenparametern. Derartige Vorrichtungen gehen in der Regel davon aus, dass die gelieferten Reifenparameter korrekt sind und ohne Einschränkungen zur weiteren Analyse und/oder Verwendung verwendet werden dürfen.

Allerdings hat sich gezeigt, dass die Validität derartiger Reifenparameter nicht immer gegeben ist. So kann es sein, dass die Vorrichtung zwar einen Reifenparameter empfängt, dieser Reifenparameter aber unter bestimmten Umständen nicht valide bzw. invalide ist und daher für eine weitere Verwendung nicht verwendet werden soll. Würde ein derartiger nicht valider Reifenparameter dennoch verwendet werden, könnte ein falsches Ergebnis ermittelt werden und/oder könnten falsche Schlüsse gezogen werden. Dies gilt es nach Möglichkeit zu vermeiden.

Die EP 0972658 A2 beschreibt ein Verfahren zur Bestimmung der Profiltiefe bei einem Fahrzeugreifen eines Fahrzeugs während der Fahrt, bei dem zunächst in einer Initialisierungsphase die an einem Fahrzeug montierten Reifen identifiziert werden und dann ein Reifenformschlupf der angetriebenen Räder bei vorbestimmten Fahrbedingungen ermittelt und entsprechend der jeweils vorliegenden Fahrbedingungen bewertet wird. Anschließend wird aus einem im Fahrzeug gespeicherten Kennfeld entsprechend dem identifizierten Reifen und dem bewerteten Reifenformschlupf eine Information über die auf den Reifen vorhandene Profiltiefe ausgegeben. Dann wird die derart bestimmte Profiltiefe gewichtet basierend auf einer Aktualität der Reifenprofiltiefenmessung, einer Reifenalterung und einer Güte der Profiltiefenmessung. Schließlich wird über eine Vielzahl von derart bestimmten, gewichteten Profiltiefen eine Mittelung zur Ermittlung einer gemittelten Profiltiefe durchgeführt und es wird die gemittelte Profiltiefe bei Fahrtende im Fahrzeug abgespeichert.

Die US 2019 009618 A1 beschreibt ein Verfahren zur Überwachung einer Lebensdauer eines Reifenprofils eines Fahrzeugreifens. Dabei wird über eine fahrzeugexterne Profiltiefenmessvorrichtung eine Profiltiefenmessung des Fahrzeugreifens durchgeführt und es wird die gemessene Profiltiefe zusammen mit einem Datum, an dem die Profiltiefenmessung durchgeführt wurde, drahtlos an eine elektronische Auswerteeinrichtung des Fahrzeugs übermittelt. Auf Grundlage der übermittelten, gemessenen Profiltiefe sowie einem in einem Speicher der Auswerteeinrichtung abgespeicherten Profiltiefenschwellenwert, der einen Schwellenwert für das Ende der Lebensdauer eines Reifenprofils bzw. eines Fahrzeugreifens darstellt, ermittelt die Auswerteeinrichtung eine voraussichtliche Lebensdauer des Reifenprofils bzw. des Fahrzeugreifens.

Die WO 2019/224641 A2 beschreibt ein Verfahren zur Verwaltung von reifenservicebezogenen Daten. Dabei werden Reifenidentifikationscodes, Reifenmessparameter wie Reifenprofiletiefen sowie Zeitstempel, die eine Information bezüglich der Erfassungszeit der Reifenmessparameter angeben, in einer, beispielsweise cloudbasierten, Datenbank gesammelt. Basierend auf den gesammelten Daten sowie hinterlegten Referenzdaten, beispielsweise Schwellenwerte für Reifenmessparameter, werden dann abgeleitete Daten wie ein Reifenabnutzungsindex zum Zeitpunkt der Erfassung eines Reifenmessparameters erzeugt.

Die DE 10 2015 223 968 A1 beschreibt ein Betriebsverfahren für eine elektronische Radeinheit und eine elektronische Auswerteeinrichtung eines Fahrzeugs. Dabei werden von der einem Fahrzeugrad zugeordneten Radeinheit Radbetriebsparameter wie ein Reifendruck des entsprechenden Reifens erfasst und die erfassten Radbetriebsparameter im Rahmen eines Datentelegramms an die elektronische Auswerteinrichtung übertragen. Ferner erzeugt die Radeinheit eine Historieninformation, die charakteristisch für Zeitpunkte von und/oder Zeitabstände zwischen in einem vergangenen Zeitraum versandten Datentelegrammen ist, und die teilweise in ein aktuell zu versendendes Datentelegramm aufgenommen wird. Zudem weist die Radeinheit einen digitalen Zähler auf, dessen Zählerstand bei einem Versand eines Datentelegramms inkrementiert wird, wobei ein jeweils aktueller Zählerstand in jedes zu versendende Datentelegramm aufgenommen ist.

Aufgabe der vorliegenden Erfindung ist es, ein Verfahren sowie eine Vorrichtung zum Feststellen einer Validität eines Reifenparameters eines Reifens eines Fahrzeugs bereitzustellen.

Diese Aufgabe wird durch ein Verfahren gemäß dem Patentanspruch 1 und durch eine Vorrichtung gemäß dem Patentanspruch 6 gelöst. Vorteilhafte Ausgestaltungen der Erfindung sind Gegenstand der Unteransprüche.

Gemäß einem ersten Aspekt der vorliegenden Erfindung wird ein Verfahren zum Feststellen einer Validität eines Reifenparameters eines Reifens eines Fahrzeugs bereitgestellt. Der Reifenparameter ist eine Referenzreifenprofiltiefe, die zur Ermittlung einer geschätzten Reifenprofiltiefe des Reifens benötigt wird. Das erfindungsgemäße Verfahren umfasst die folgenden Schritte: Erfassen des Reifenparameters, Erfassen eines Werts eines Validitätsparameters, wobei der Validitätsparameter ein Maß für die Validität des erfassten Reifenparameters ist, Feststellen, dass der erfasste Reifenparameter valide ist, wenn der erfasste Wert des Validitätsparameters im Vergleich zu einem vorherigen Wert des Validitätsparameters geändert ist, und Verwenden des erfassten Reifenparameters für die Berechnung einer abgeschätzten Reifenprofiltiefe, wenn festgestellt wurde, dass der erfasste Reifenparameter valide ist. Der Validitätsparameter kann als eine Art Zusatzinformation für den erfassten Reifenparameter erachtet werden. Diese Zusatzinformation, die dem Reifenparameter anhaftet und beispielsweise zusammen mit dem Reifenparameter einer Steuerelektronik übermittelt wird, erlaubt es, diesen Reifenparameter zu bewerten. Die Bewertung "valide" bedeutet beispielsweise, dass dem Reifenparameter vertraut werden kann. Wenn der Reifenparameter "nicht valide" ist, dann bedeutet das, dass dem Reifenparameter nicht vertraut werden kann. Das hat dann bspw. zur Folge, dass die Steuerelektronik aufgrund der übermittelte Zusatzinformation den Reifenparameter nicht verwendet und/oder z.B. für weiterführende Analysen, die auf dem erfassten Reifenparameter basieren würden, nicht berücksichtigt.

Das erfindungsgemäße Verfahren beruht zudem auf der Idee, dass ein Reifenparameter durchaus bereits einen Wert eines Validitätsparameters haben kann. Beispielsweise kann dies ein beliebiger (voreingestellter) Wert sein, bspw. ein Wert von 0 oder dergleichen. Der Wert des Validitätsparameters kann auch ein Datum sein. Bspw. kann der Wert das Datum sein, an dem der Reifen letztmalig begutachtet wurde. Das erfindungsgemäße Verfahren beruht nun auf der Idee, dass eine Änderung des Werts des Validitätsparameters von dem bislang hinterlegten Wert des Validitätsparameters auf einen dann geänderten Wert des Validitätsparameters dazu benutzt wird, um festzustellen, dass der erfasste Reifenparameter in Ordnung, also valide, ist und damit dem Reifenparameter vertraut werden kann. Beispielsweise kann der bislang eingestellte Wert des Validitätsparameters der Wert 0 aufweisen. Dieser Wert wird nun bspw. werkstattseitig auf 1 geändert. Oder der bislang eingestellte Wert des Validitätsparameters war das Datum der letzten Reifenbegutachtung und dieser Wert wird nun beispielsweise auf das Datum der aktuellen Reifenbegutachtung geändert. Die Erfindung beruht auf der Idee, dass eine derartige Änderung des Werts des Validitätsparameters dazu genutzt wird, um die Validität des erfassten Reifenparameters festzustellen. Mit anderen Worten wäre ein Reifenparameter, der einer Steuerelektronik mitgeteilt wird, gerade nicht valide, wenn keine Änderung des Werts des Validitätsparameters im Vergleich zum vorherigen Wert des Validitätsparameters erfolgt ist. Der erfasste Reifenparameter würde dann gerade nicht verwendet werden.

In einer bevorzugten Ausgestaltung erfolgt der Schritt des Verwendens des Reifenparameters zur Ermittlung der abgeschätzten Reifenprofiltiefe innerhalb eines vorgegebenen Zeitfensters. Konkret ist der erfasste Reifenparameter eine Referenzreifenprofiltiefe, die beispielsweise in der Werkstatt oder bei Auslieferung des Fahrzeugs hinterlegt wurde. Bspw. kann ein solcher Wert 4 mm sein. Dieser Wert könnte dann zur Ermittlung einer geschätzten Reifenprofiltiefe des Reifens verwendet werden, bspw. basierend auf Rechenmodellen, die mittels der Referenzreifenprofiltiefe initialisiert werden. Sofern nun festgestellt wurde, dass die Referenzreifenprofiltiefe valide ist, wird diese Referenzreifenprofiltiefe zur Ermittlung der abgeschätzten Reifenprofiltiefe verwendet. Wenn allerdings festgestellt wurde, dass die Referenzreifenprofiltiefe nicht valide ist, dann wird diese Referenzreifenprofiltiefe nicht zur Ermittlung der abgeschätzten Reifenprofiltiefe ermittelt. Das mathematische Rechenmodell wird also gerade nicht neu initialisiert.

Wie bereits angesprochen, wird festgestellt, dass der erfasste Reifenparameter valide ist, wenn der erfasste Wert des Validitätsparameters im Vergleich zu einem vorherigen Wert geändert ist. Besonders vorteilhaft es ist es, wenn der Wert des Validitätsparameters bei einem Reifenwechsel geändert wird. Der Reifenwechsel stellt dabei das Wechseln des (Gummi)Reifens von der Radfelge dar. Dazu muss beispielsweise der Reifendruck komplett abgelassen werden, der Reifen muss von der Felge gezogen werden, ein neuer Reifen muss auf die Felge gezogen werden und der Reifendruck muss wieder an den gewünschten Reifendruck angepasst werden.

In der bevorzugten Ausgestaltung des erfindungsgemäßen Verfahrens ist vorgesehen, dass bei einem derartigen Reifenwechsel beispielsweise von der Werkstatt des Fahrzeugs eine Änderung des Werts des Validitätsparameters vorgenommen wird. In diesem Fall würde bspw. der Wert des Validitätsparameters von 0 auf 1 geändert werden. Dadurch, dass nunmehr der Wert des Validitätsparameters geändert ist im Vergleich zum vorherigen Wert, würde die Steuerelektronik feststellen, dass der erfasste Reifenparameter, also im konkreten Beispiel die Referenzreifenprofiltiefe iHv 4 mm, valide ist und damit bspw. für die Berechnung einer abgeschätzten Reifenprofiltiefe verwendet werden darf. Die Steuerelektronik würde also die Initialisierung des mathematischen Modells starten.

Besonders vorteilhaft es ist es, wenn in diesem Zusammenhang der Wert des Validitätsparameters das Datum ist, an dem der Reifenwechsel durchgeführt wird. Weiter vorteilhaft ist es, wenn das vorgegebene Zeitfenster, innerhalb dessen der Reifenparameter zur Ermittlung des weiteren Reifenparameters verwendet werden darf, in einem Bereich von bspw. 2 bis 6 Wochen liegt. Bei dieser vorteilhaften Ausgestaltung kann nunmehr basierend auf dem Datum des letzten Reifenwechsels und basierend auf dem vorgegebenen Zeitfenster definiert werden, wann der weitere Reifenparameter spätestens zu ermitteln ist. Im konkreten Beispiel würde also die Steuerelektronik die Initialisierung des mathematischen Modells zur Ermittlung der abgeschätzten Reifenprofiltiefe innerhalb von 2 bis 6 Wochen nach dem letzten Reifenwechsel starten. Diese besonders bevorzugte Ausgestaltung ermöglicht es, insbesondere die Reifenprofiltiefe des Reifens korrekt abzuschätzen, da die als valide erfasste Referenzreifenprofiltiefe nur innerhalb des vorgegebenen Zeitfensters zur Ermittlung der abgeschätzten Reifenprofiltiefe des Reifens verwendet wird.

Gemäß einem zweiten Aspekt der vorliegenden Erfindung wird eine Vorrichtung zum Feststellen einer Validität eines Reifenparameters eines Reifens eines Fahrzeugs bereitgestellt. Die Vorrichtung umfasst eine Reifenparametererfassungseinheit zum Erfassen des Reifenparameters, wobei der Reifenparameter eine Referenzreifenprofiltiefe ist, eine Validitätsparametererfassungseinheit zum Erfassen eines Werts eines Validitätsparameters, wobei der Validitätsparameter ein Maß für die Validität des Reifenparameters ist, und eine Steuereinheit, die dazu ausgebildet ist, die Validität des Reifenparameters festzustellen, wenn der erfasste Wert des Validitätsparameters im Vergleich zu einem vorherigen Wert des Validitätsparameters geändert ist, und die ferner dazu ausgebildet ist, den erfassten Reifenparameter für die Berechnung einer abgeschätzten Reifenprofiltiefe zu verwenden, wenn festgestellt wurde, dass der erfasste Reifenparameter valide ist. Bevorzugt ist die Steuereinheit weiter dazu ausgebildet, die Verfahrensschritte des erfindungsgemäßen Verfahrens gemäß dem ersten Aspekt bzw. Ausgestaltungen davon auszuführen.

Weitere Merkmale und Aufgaben der vorliegenden Erfindung werden dem Fachmann durch Ausüben der vorliegenden Lehre und Betrachten der beiliegenden Zeichnungen ersichtlich. Es zeigen:
FIG 1 eine schematische Darstellung eines Ablaufdiagramms einer Ausführungsform eines erfindungsgemäßen Verfahrens zum Feststellen einer Validität eines Reifenparameters,
FIG 2 eine schematische Darstellung eines Ablaufdiagramms einer weiteren Ausführungsform des erfindungsgemäßen Verfahrens,
FIG 3 eine schematische Darstellung eines Ablaufdiagramms einer weiteren Ausführungsform des erfindungsgemäßen Verfahrens, sowie
FIG 4 eine schematische Darstellung einer Ausführungsform einer erfindungsgemäßen Vorrichtung zum Feststellen einer Validität eines Reifenparameters.

Elemente gleicher Konstruktion oder Funktion sind figurenübergreifend mit den gleichen Bezugszeichen versehen.

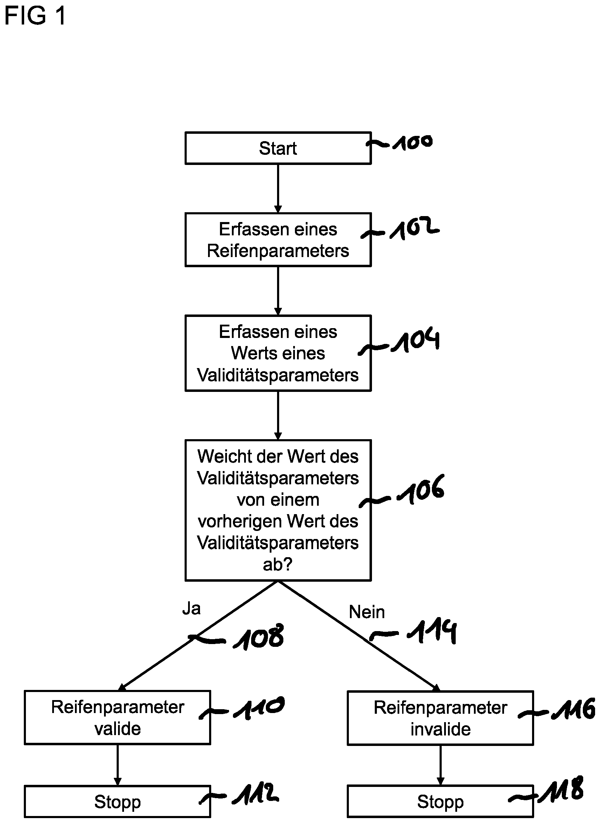

FIG 1 zeigt eine schematische Darstellung eines Ablaufdiagramms einer Ausführungsform eines erfindungsgemäßen Verfahrens zum Feststellen einer Validität eines Reifenparameters.

Das Verfahren startet bei Schritt 100. Im darauffolgenden Schritt 102 wird ein Reifenparameter erfasst. Der Reifenparameter kann beispielsweise eine Referenzreifenprofiltiefe des Reifens des Fahrzeugs sein. Im darauffolgenden Schritt 104 wird ein Wert eines Validitätsparameters erfasst. Der Validitätsparameter gibt ein Maß für die Validität des erfassten Reifenparameters an. Im darauffolgenden Schritt 106 wird festgestellt, ob der Wert des erfassten Validitätsparameters von einem vorherigen Wert des Validitätsparameters abweicht. Weicht der erfasste Wert des Validitätsparameters von dem vorherigen Wert ab (Zweig 108), dann wird im Schritt 110 festgestellt, dass der erfasste Reifenparameter valide ist und das Verfahren stoppt beim Schritt 112. Weicht der Wert des erfassten Validitätsparameters jedoch nicht von dem vorherigen Wert ab (Zweig 114), dann wird im Schritt 116 festgestellt, dass der erfasste Reifenparameter nicht valide ist und das Verfahren stoppt beim Schritt 118. Mit dem Verfahren gemäß FIG 1 kann somit dem erfassten Reifenparameter in Form einer Änderung des Werts des Validitätsparameters die Zusatzinformation mit auf den Weg gegeben werden, dass der erfasste Reifenparameter valide oder eben nicht valide ist.

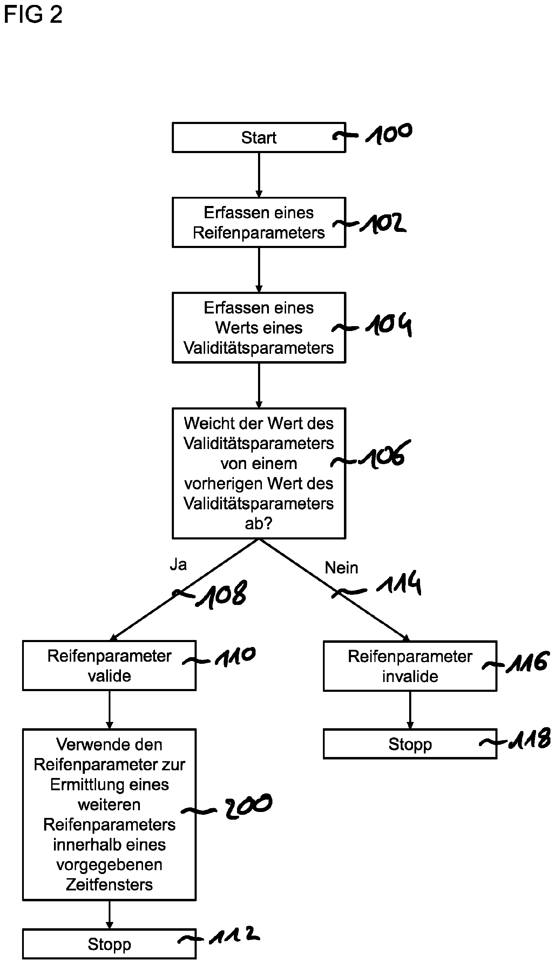

FIG 2 zeigt eine schematische Darstellung eines Ablaufdiagramms einer weiteren Ausführungsform des erfindungsgemäßen Verfahrens. Das Verfahren gemäß FIG 2 weist die Schritte 100 bis 118 des Verfahrens gemäß FIG 1 auf. Das Verfahren gemäß FIG 2 unterscheidet sich jedoch von dem Verfahren gemäß FIG 1 darin, dass, wenn bei dem Schritt 110 festgestellt wurde, dass der erfasste Reifenparameter valide ist, dieser erfasste Reifenparameter zur Ermittlung eines weiteren Reifenparameters verwendet werden soll, wobei die Verwendung nur innerhalb eines vorgegebenen Zeitfensters erfolgen darf. Dies ist im Ablaufdiagramm von FIG 2 durch den zusätzlichen Schritt 200 zwischen den Schritten 110 und 112 dargestellt. Das vorgegebene Zeitfenster kann beispielsweise in einem Bereich von 2 bis 6 Wochen liegen und der angesprochene weitere Reifenparameter kann beispielsweise eine abgeschätzte Reifenprofiltiefe sein, die basierend auf der erfassten Referenzreifenprofiltiefe ermittelt wird.

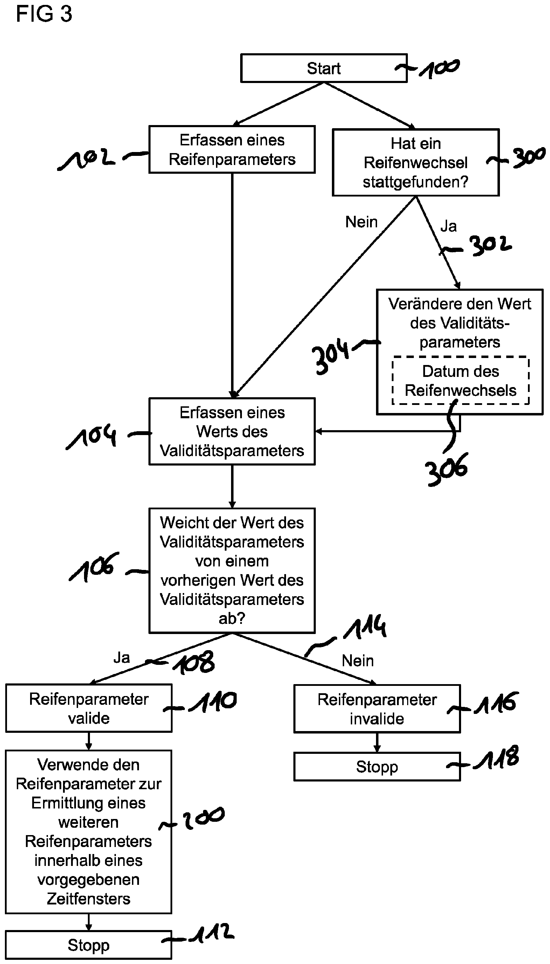

FIG 3 zeigt eine schematische Darstellung eines Ablaufdiagramms einer weiteren Ausführungsform des erfindungsgemäßen Verfahrens. Das Verfahren gemäß FIG 3 basiert auf dem Verfahren gemäß FIG 2 und weist ebenso wie das Verfahren gemäß FIG 2 die Schritte 100 bis 118 sowie den Schritt 200 auf. Das Verfahren gemäß FIG 3 unterscheidet sich jedoch vom Verfahren gemäß FIG 2 darin, dass in einem Schritt 300 festgestellt wird, ob ein Reifenwechsel stattgefunden hat. Ein Reifenwechsel bedeutet in diesem Zusammenhang das Abziehen und Aufziehen eines (Gummi)Reifens von der Felge bzw. auf die Felge, was ein Ablassen des Reifendrucks und ein Wiederbefüllen des Reifens zur Folge hat.

Wird festgestellt, dass ein derartiger Reifenwechsel stattgefunden hat (Zweig 302), dann wird im Schritt 304 der Wert des Validitätsparameters verändert, indem das Datum des Tages, an dem der Reifenwechsel durchgeführt wird, eingetragen wird (gestrichelte Box 306). Die Veränderung des Werts des Validitätsparameters führt dazu, dass der Wert des Validitätsparameters valide ist, und hat darüber hinaus den Vorteil, dass nunmehr in Zusammenhang mit dem in Schritt 200 vorgegebenen Zeitfenster ein Ablaufdatum bestimmt werden kann, bis wann der erfasste Reifenparameter zur Ermittlung des weiteren Reifenparameters benutzt werden darf.

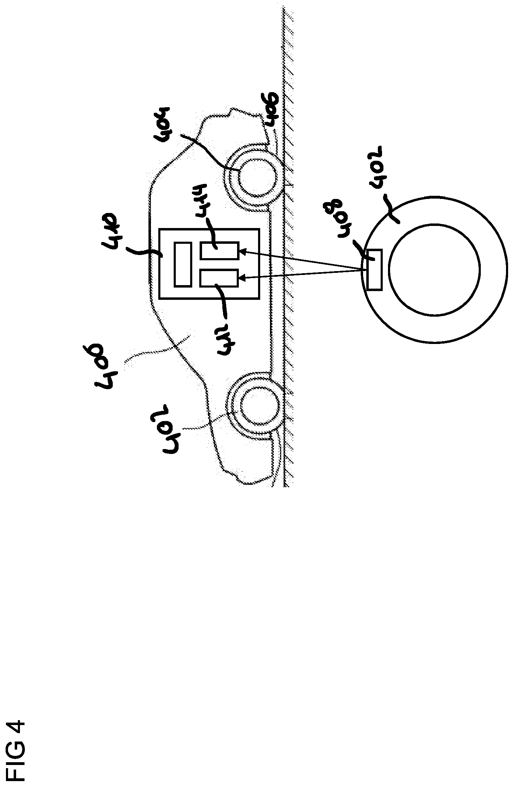

Es sei noch auf FIG 4 verwiesen, die eine schematische Darstellung einer Ausführungsform einer erfindungsgemäßen Vorrichtung zum Feststellen einer Validität eines Reifenparameters eines Reifens 402 eines Fahrzeugs 400 zeigt. Der Reifen 402 weist eine Felge 404 und einen Gummi 406 auf. Der Reifen 402 weist ferner einen Reifensensor 408 auf, der einen Reifenparameter des Reifens 402 erfasst. Der Reifensensor 408 ist mit einer Steuereinheit 410 signaltechnisch verbunden und kann den erfassten Reifenparameter an die Steuereinheit 410 übermitteln. Der Reifensensor 408 kann auch einen Validitätsparameter an die Steuereinheit 410 übermitteln. Die Steuereinheit 410 weist hierfür eine Reifenparametererfassungseinheit 412 zum Erfassen des Reifenparameters sowie eine Validitätsparametererfassungseinheit 414 zum Erfassen des Werts des Validitätsparameters auf. Selbstverständlich ist es auch möglich, dass der Validitätsparameter direkt in die Validitätsparametererfassungseinheit 414 eingetragen werden kann, ohne den Reifensensor 408 bemühen zu müssen. Dies kann bspw. durch einen Mitarbeiter einer Werkstatt erfolgen. Die Steuereinheit 410 ist ferner dazu ausgebildet, die in Zusammenhang mit FIG 1 bis 3 erwähnten Schritte durchzuführen. Damit wird eine Vorrichtung geschaffen, die die Validität eines Reifenparameters feststellt und diesen ggf. für weitere Auswertungen bzw. Schritte nutzt.

## Patentansprüche

1. Verfahren zum Feststellen einer Validität eines Reifenparameters eines Reifens (402) eines Fahrzeugs (400), umfassend die folgenden Schritte:
- Erfassen des Reifenparameters, wobei der Reifenparameter eine Referenzreifenprofiltiefe ist,
- Erfassen eines Werts eines Validitätsparameters, wobei der Validitätsparameter ein Maß für die Valididät des Reifenparameters ist,
- Feststellen, dass der erfasste Reifenparameter valide ist, wenn der erfasste Wert des Validitätsparameters im Vergleich zu einem vorherigen Wert des Validitätsparameters geändert ist, und
- Verwenden des erfassten Reifenparameters für die Berechnung einer abgeschätzten Reifenprofiltiefe, wenn festgestellt wurde, dass der erfasste Reifenparameter valide ist.

2. Verfahren nach Anspruch 1, wobei, der Schritt des Verwendens des Reifenparameters zur Ermittlung der abgeschätzten Reifenprofiltiefe innerhalb eines vorgegebenen Zeitfensters erfolgt.

3. Verfahren nach Anspruch 1 oder 2, wobei der Wert des Validitätsparameters bei einem Reifenwechsel geändert wird.

4. Verfahren nach Anspruch 3, wobei der Wert des Validitätsparameters das Datum ist, an dem der Reifenwechsel durchgeführt wird.

5. Verfahren nach einem der Ansprüche 2 bis 4, wobei das vorgegebene Zeitfenster, innerhalb dessen der Reifenparameter zur Ermittlung des weiteren Reifenparameters verwendet wird, ein Bereich von zwei bis sechs Wochen ist.

6. Vorrichtung zum Feststellen einer Validität eines Reifenparameters eines Reifens (402) eines Fahrzeugs (400), mit den folgenden Komponenten:
- eine Reifenparametererfassungseinheit (412) zum Erfassen des Reifenparameters, wobei der Reifenparameter eine Referenzreifenprofiltiefe ist,
- eine Validitätsparametererfassungseinheit (414) zum Erfassen eines Werts eines Validitätsparameters, wobei der Validitätsparameter ein Maß für die Valididät des Reifenparameters ist, und
- eine Steuereinheit (410), die dazu ausgebildet ist, die Validität des Reifenparameters festzustellen, wenn der erfasste Wert des Validitätsparameters im Vergleich zu einem vorherigen Wert des Validitätsparameters geändert ist, und die ferner dazu ausgebildet ist, den erfassten Reifenparameter für die Berechnung einer abgeschätzten Reifenprofiltiefe zu verwenden, wenn festgestellt wurde, dass der erfasste Reifenparameter valide ist.

## Claims

1. Method for determining the validity of a tyre parameter of a tyre (402) of a vehicle (400), comprising the following steps:
- recording the tyre parameter, the tyre parameter being a reference tyre tread depth,
- recording a value of a validity parameter, the validity parameter being a measure of the validity of the tyre parameter,
- determining that the recorded tyre parameter is valid if the recorded value of the validity parameter has changed compared to a previous value of the validity parameter, and
- using the recorded tyre parameter to calculate an estimated tyre tread depth if it has been determined that the recorded tyre parameter is valid.

2. Method according to Claim 1, wherein the step of using the tyre parameter to ascertain the estimated tyre tread depth takes place within a predefined time window.

3. Method according to Claim 1 or 2, wherein the value of the validity parameter is changed during a tyre change.

4. Method according to Claim 3, wherein the value of the validity parameter is the date on which the tyre change is carried out.

5. Method according to one of Claims 2 to 4, wherein the predefined time window within which the tyre parameter is used to ascertain the further tyre parameter is a range of two to six weeks.

6. Device for determining the validity of a tyre parameter of a tyre (402) of a vehicle (400), comprising the following components:
- a tyre parameter recording unit (412) for recording the tyre parameter, the tyre parameter being a reference tyre tread depth,
- a validity parameter recording unit (414) for recording a value of a validity parameter, the validity parameter being a measure of the validity of the tyre parameter, and
- a control unit (410) that is designed to determine the validity of the tyre parameter if the recorded value of the validity parameter has changed compared to a previous value of the validity parameter, and that is also designed to use the recorded tyre parameter to calculate an estimated tyre tread depth if it has been determined that the recorded tyre parameter is valid.

## Revendications

1. Procédé de détermination de validité d'un paramètre de pneumatique d'un pneumatique (402) d'un véhicule (400), comprenant les étapes suivantes :
- détecter le paramètre de pneumatique, le paramètre de pneumatique étant une profondeur de profil de pneumatique de référence,
- détecter une valeur d'un paramètre de validité, le paramètre de validité étant une mesure de la validité du paramètre de pneumatique,
- déterminer que le paramètre de pneumatique détecté est valide lorsque la valeur détectée du paramètre de validité est modifiée par rapport à une valeur précédente du paramètre de validité, et
- utiliser le paramètre de pneumatique détecté pour le calcul d'une profondeur de profil de pneumatique estimée lorsqu'il a été déterminé que le paramètre de pneumatique détecté est valide.

2. Procédé selon la revendication 1, dans lequel l'étape d'utilisation du paramètre de pneumatique pour déterminer la profondeur de profil de pneumatique estimée est effectuée dans une fenêtre temporelle prédéfinie.

3. Procédé selon la revendication 1 ou 2, dans lequel la valeur du paramètre de validité est modifiée lors d'un changement de pneumatique.

4. Procédé selon la revendication 3, dans lequel la valeur du paramètre de validité est la date à laquelle le changement de pneumatique est effectué.

5. Procédé selon l'une des revendications 2 à 4, dans lequel la fenêtre temporelle prédéfinie à l'intérieur de laquelle le paramètre de pneumatique est utilisé pour déterminer l'autre paramètre de pneumatique, est une plage allant de deux à six semaines.

6. Dispositif de détermination de validité d'un paramètre de pneumatique d'un pneumatique (402) d'un véhicule (400), comprenant les composants suivants :
- une unité de détection de paramètre de pneumatique (412) destinée à détecter le paramètre de pneumatique, le paramètre de pneumatique étant une profondeur de profil de pneumatique de référence,
- une unité de détection de paramètre de validité (414) destinée à détecter une valeur d'un paramètre de validité, le paramètre de validité étant une mesure de la validité du paramètre de pneumatique, et
une unité de commande (410), qui est conçue pour déterminer la validité du paramètre de pneumatique lorsque la valeur détectée du paramètre de validité est modifiée par comparaison à une valeur précédente du paramètre de validité, et qui est en outre conçue pour utiliser le paramètre de pneumatique détecté pour le calcul d'une profondeur de profil de pneumatique estimée lorsqu'il a été déterminé que le paramètre de pneumatique détecté est valide.
